# EUROPÄISCHE PATENTSCHRIFT

(11) **EP 0 654 820 B1**
(45) Veröffentlichungstag und Bekanntmachung des Hinweises auf die Patenterteilung: **02.09.1998**
(21) Anmeldenummer: 94117619.0
(22) Anmeldetag: 08.11.1994
(51) Int. Cl.: H01L 23/367, H01L 25/04, H01L 23/13

(54) **Halbleiter-Modul mit konvexer Bodenplatte**
Semiconductor module with convex base plate
Module à semi-conducteurs avec plaque de base convexe

(30) Priorität: 08.11.1993 DE 4338107
(43) Veröffentlichungstag der Anmeldung: 24.05.1995
(73) Patentinhaber: EUPEC Europäische Gesellschaft für Leistungshalbleiter mbH & Co. KG, D-59581 Warstein (DE)
(72) Erfinder: Köhler, Werner, D-59581 Warstein (DE); Spanke, Reinhold, Dipl.-Ing., D-59909 Bestwig (DE)
(74) Vertreter: Epping, Wilhelm, Dr.-Ing.

(56) Entgegenhaltungen:
- PATENT ABSTRACTS OF JAPAN vol. 006 no. 052 (E-100) ,7.April 1982 & JP-A-56 165329 (HITACHI LTD) 18.Dezember 1981,
- PATENT ABSTRACTS OF JAPAN vol. 002 no. 053 (E-027) ,17.April 1978 & JP-A-53 017072 (NEC CORP) 16.Februar 1978,

## Beschreibung

Die Erfindung bezieht sich auf ein Halbleiter-Modul mit einem elektrisch isolierenden und thermisch leitenden Substrat, das auf die Oberseite einer Metall-Bodenplatte verlötet ist, und mit Halbleiterchips, die auf die Oberseite des Substrats verlötet sind und bei dem die Unterseite der Bodenplatte konvex ausgebildet ist.

Ein solches Halbleiter-Modul ist z.B. in der DE 39 40 933 A1 beschrieben worden. Die konvexe Ausbildung der Bodenplatte hat den Zweck, einen einwandfreien thermischen Kontakt zwischen ihr und einem Kühlkörper auch im Betrieb des Halbleiter-Moduls zu ermöglichen. Die bezüglich des Kühlkörpers konvex verformte Bodenplatte wird an ihren Enden an den Kühlkörper angeschraubt. Damit liegt die Bodenplatte mit ihrer ganzen Fläche am Kühlkörper an. Die konvexe Verformung wird so groß gewählt, daß im Betrieb ein Aufwölben der Bodenplatte in der Mitte nicht auftritt.

Bei dem im genannten Stand der Technik beschriebenen Modul ist die Bodenplatte über ihre gesamte Fläche gleich dick. Eine bezüglich des Kühlkörpers konvexe Verformung bewirkt daher auf der Oberseite eine konkave Verformung. Da sowohl das Substrat mit der Bodenplatte als auch die Halbleiterchips mit dem Substrat zumeist durch Weichlöten verbunden werden, hat das Lot im flüssigen Zustand die Tendenz, wegzulaufen. Damit ist jedoch eine einfache Montage sowohl des Substrats als auch der Halbleiterchips durch einfache Lötformen nicht möglich. Eine einfache Montage wird umso mehr erschwert, je größer die Konvexitat der Bodenplatte ist und je mehr Teile auf der Bodenplatte montiert werden müssen.

Aus JP-A-56-165329 ist ein SMD-Transistor bekannt, bei dem auf der Kollektor-Seite ein Leitender Kopfstuck mit einer planaren Oberseite und einer konvexen Unterseite vorgesehen ist. Die dort vorgeschlagene konvexe Unterseite dient zur besseren Verlötbarkeit mit einem darunter befindlichen Substrat.

Ziel der Erfindung ist es, ein Halbleiter-Modul der erwähnten Gattung so weiterzubilden, daß eine einfache Montage mit einfachen Lötformen möglich wird, ein einwandfreier thermischer Kontakt zwischen Bodenplatte und Kühlkörper jedoch gewährleistet bleibt.

Dieses Ziel wird dadurch erreicht, daß die Oberseite der Bodenplatte plan ist.

Weiterbildungen der Erfindung sind Gegenstand der Unteransprüche.

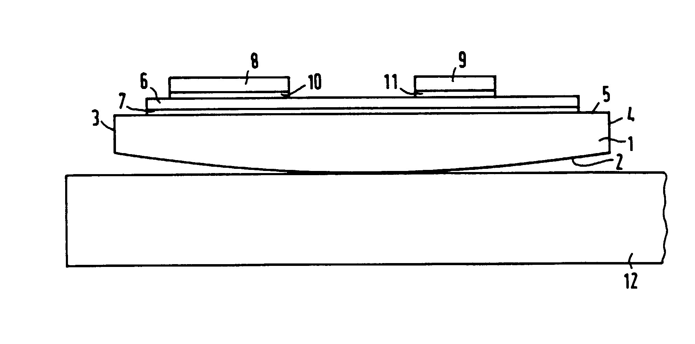

Die Erfindung wird anhand eines Ausführungsbeispiels in Verbindung mit der Figur näher erläutert. Es sei angemerkt, daß sowohl die konvexe Krümmung der Unterseite der Bodenplatte als auch die Dicke der zu montierenden Teile aus Gründen der besseren Darstellung übertrieben dargestellt ist.

In der Figur ist die Bodenplatte mit 1 bezeichnet. Sie besteht im allgemeinen aus einem gut wärmeleitenden Metall, z.B. aus Kupfer. Die Bodenplatte hat eine bezüglich eines Kühlkörpers 12 konvexe Unterseite 2 und eine plane Oberseite 5. Auf der Oberseite 5 ist ein thermisch gut leitendes, elektrisch isolierendes Substrat 6 angeordnet. Dies besteht üblicherweise aus Aluminiumoxid Al₂O₃ oder Aluminiumnitrid AlN und ist mit lötfähigen Leiterbahnen versehen. Das

Substrat 6 wird mit der Oberseite 5 der Bodenplatte 1 durch eine Weichlotschicht 7 verbunden. Auf der Oberseite des Substrats 6 sind über Weichlotschichten 10, 11 Halbleiterchips 8, 9 befestigt. Diese können dann über die Leiterbahnen miteinander und mit Gehäuseanschlüssen verbunden sein. Die Oberseiten der Halbleiterchips 8, 9 sind üblicherweise über Bondverbindungen miteinander und mit den genannten Leiterbahnen verbunden.

Dadurch, daß die Oberfläche 5 plan ausgebildet ist, läßt sich die Montage der Teile 6, 8 und 9 stark vereinfachen. Für die Montage des Substrats 6 wird auf die Oberseite eine erste Lötform aufgelegt. In diese wird dann eine Lötfolie eingelegt und darauf das Substrat 6. Diese Teile werden dann in einem Durchlaufofen erhitzt. Beim Erhitzen des Lots verbleibt dieses durch die Kapillarwirkung zwischen der Oberseite 5 und dem Substrat 6 zwischen diesen Teilen, so daß die genannten Teile einfach und sicher reproduzierbar miteinander verlötet werden können. In einem zweiten Durchlauf werden die Halbleiterchips 8, 9 in eine zweite Lötform eingesetzt und dann im Durchlaufofen mit der Oberseite des Substrat 6 verlötet. Zweckmäßigerweise hat das für die Verlötung der Halbleiterchips 8, 9 mit dem Substrat 6 verwendete Lot einen niedrigeren Schmelzpunkt als das Lot der Lotschicht 7.

Nachdem das Modul mit Anschlußleitern, einem Gehäuse und einer Gehäusefüllung versehen ist, wird es über die Bodenplatte an ihren Enden 3, 4 durch Schrauben auf den Kühlkörper 12 aufgeschraubt. Dabei verformt sich die Bodenplatte 1, bis die Unterseite 2 plan anliegt. Die Oberseite verformt sich konvex. Die zwischen den verlöteten Teilen auftretenden mechanischen Kräfte werden durch die Lotschichten 7, 10 und 11 aufgefangen.

Ist die Bodenplatte beträchtlich länger als breit, so genügt u.U. eine konvexe Verformung der Unterseite 2 in der Längsrichtung. Bei Bodenplatten, deren Querabmessungen recht groß sind und z.B. in der Größe der Querabmessungen liegen, empfiehlt sich eine konvexe Verformung in beiden Richtungen. Der Unterseite 2 kann in diesem Fall z.B. die Form einer Kugelkalotte gegeben werden.

In einem praktischen Ausführungsbeispiel hat die Bodenplatte eine Länge von 137 mm und eine Breite von 127 mm. Ihre Dicke beträgt außen 5 mm, ihre größte Dicke in der Mitte liegt bei 5,4 bis 5,5 mm. Ein solches Modul wird dann durch 6 Schrauben auf dem Kühlkörper befestigt.

## Patentansprüche

1. Halbleiter-Modul mit einem elektrisch isolierenden und thermisch leitenden Substrat, das auf die Oberseite einer Metall-Bodenplatte verlötet ist, und mit Halbleiterchips, die auf die Oberseite des Substrats verlötet sind, wobei die Bodenplatte auf einem Kühlkörper verschraubbar ist, und bei dem die Unterseite der Bodenplatte konvex ausgebildet ist,
**dadurch gekennzeichnet,** daß die Oberseite (5) der Bodenplatte (1) plan ist.

2. Halbleiter-Modul nach Anspruch 1,
**dadurch gekennzeichnet,** daß die Unterseite (2) der Bodenplatte (1) in Längs- und in Querrichtung konvex ausgebildet ist.

3. Halbleiter-Modul nach Anspruch 2,
**dadurch gekennzeichnet,** daß die Unterseite (2) der Bodenplatte die Form einer Kugelkalotte hat.

## Claims

1. Semiconductor module having an electrically insulating and thermally insulating substrate which is soldered onto the top side of a metal baseplate, and having semiconductor chips which are soldered onto the top side of the substrate, it being possible for the baseplate to be screwed onto a heat sink, and in which the under side of the baseplate is of convex construction, characterized in that the top side (5) of the baseplate (1) is flat.

2. Semiconductor module according to Claim 1, characterized in that the under side (2) of the baseplate (1) is constructed in a convex fashion in the longitudinal and transverse directions.

3. Semiconductor module according to Claim 2, characterized in that the underside (2)of the baseplate has the shape of a spherical cap.

## Revendications

1. Module à semi-conducteurs comportant un substrat isolant électriquement et conducteur thermiquement, soudé sur la face supérieure d'une plaque de base métallique, et des puces à semi-conducteurs, qui sont soudées sur la face supérieure du substrat, la plaque de base étant vissable à l'élément de refroidissement, et dans lequel la face inférieure de la plaque de base est conçue de forme convexe,
**caractérisé en ce que** la face supérieure (5) de la plaque de base (1) est plane.

2. Module à semi-conducteurs selon la revendication 1,
**caractérisé en ce que** la face inférieure (2) de la plaque de base (1) est conçue de forme convexe dans le sens longitudinal et transversal.

3. Module à semi-conducteurs selon la revendication 2,
**caractérisé en ce que** la face inférieure (2) de la plaque de base a la forme d'une calotte sphérique.
